# EUROPEAN PATENT APPLICATION

(11) **EP 3 032 564 A1**
(43) Date of publication of application: **15.06.2016**
(21) Application number: 14197422.0
(22) Date of filing: 11.12.2014
(51) Int. Cl.: H01J 37/26, H01J 37/20

(54) **Improved cryogenic specimen holder for a charged particle microscope**

(71) Applicant: FEI Company, Hillsboro, OR 97124-5793 (US)
(72) Inventor: Van den Boom, Steijn, 5663 JX Geldrop (NL); Dona, Pleun, 5504 KN Veldhoven (NL)
(74) Representative: Bakker, Hendrik

(57) **Abstract**

A specimen holder (H) for a Charged Particle Microscope, comprising:
- A vessel (1) for containing a coolant fluid;
- An elongated member (3), a first end (3a) of which is thermally connected to said vessel via connection means (5) and the second end (3b) of which comprises a specimen mounting area (7), the member having a longitudinal axis (3') that extends along its length between said first and second ends,
wherein said elongated member can be rotated about said longitudinal axis relative to said vessel. Said connection member may, for example, comprise one or more of:
- A bearing chase (9) that facilitates said rotation;
- A compliant element (19) that forms a flexible thermal bridge between said vessel and said elongated member;
- A vacuum seal (17) between said elongated member and said vessel;
- An actuator (13), for effecting relative rotation of said elongated member and said vessel about said longitudinal axis, in response to a correctional/righting signal from a level sensor, for instance.

## Description

The invention relates to a specimen holder for a Charged Particle Microscope, comprising:
- A vessel for containing a coolant fluid;
- An elongated member, a first end of which is thermally connected to said vessel *via* connection means and the second end of which comprises a specimen mounting area, the member having a longitudinal axis that extends along its length between said first and second ends.

The invention correspondingly relates to a Charged Particle Microscope comprising such a specimen holder, and to a method of using such a Charged Particle Microscope.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" tools (*e.g.* a FIB-SEM), which additionally employ a "machining" Focused Ion Beam (FIB), allowing supportive activities such as ion-beam milling or lon-Beam-Induced Deposition (IBID), for example. More specifically:
- In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.org/wiki/Electron microscope
http://en.wikipedia.org/wiki/Scanning electron microscope
http://en.wikipedia.org/wiki/Transmission electron microscopy
http://en.wikipedia.org/wiki/Scanning transmission electron microscopy

As an alternative to the use of electrons as irradiating beam, charged particle microscopy can also be performed using other species of charged particle. In this respect, the phrase "charged particle" should be broadly interpreted as encompassing electrons, positive ions (*e.g.* Ga or He ions), negative ions, protons and positrons, for instance. As regards ion-based microscopy, some further information can, for example, be gleaned from sources such as the following:
http://en.wikipedia.org/wiki/Scanning Helium Ion Microscope
- W.H. Escovitz, T.R. Fox and R. Levi-Setti, Scanning Transmission Ion Microscope with a Field Ion Source, Proc. Nat. Acad. Sci. USA 72(5), pp. 1826-1828 (1975).

It should be noted that, in addition to imaging, a charged particle microscope may also have other functionalities, such as performing spectroscopy, examining diffractograms, performing (localized) surface modification (*e.g.* milling, etching, deposition), *etc.*

In all cases, a Charged Particle Microscope (CPM) will comprise at least the following components:
- A radiation source, such as a Schottky electron source or ion gun.
- An illuminator, which serves to manipulate a "raw" radiation beam from the source and perform upon it certain operations such as focusing, aberration mitigation, cropping (with an aperture), filtering, *etc.* It will generally comprise one or more (charged-particle) lenses, and may comprise other types of (particle-)optical component also. If desired, the illuminator can be provided with a deflector system that can be invoked to cause its output beam to perform a scanning motion across the specimen being investigated.
- A specimen holder, on which a specimen under investigation can be held and positioned (*e.g.* tilted, rotated). If desired, this holder can be moved so as to effect scanning motion of the beam w.r.t. the specimen. In general, such a specimen holder will be connected to a positioning system such as a mechanical stage.
- A detector (for detecting radiation emanating from an irradiated specimen), which may be unitary or compound/distributed in nature, and which can take many different forms, depending on the radiation being detected. Examples include photomultipliers (including solid state photomultipliers, SSPMs), photodiodes, CMOS detectors, CCD detectors, photovoltaic cells, *etc.,* which may, for example, be used in conjunction with a scintillator film, for instance.

In the case of a transmission-type microscope (such as a (S)TEM, for example), the CPM will also comprise:
- An imaging system, which essentially takes charged particles that are transmitted through a specimen (plane) and directs (focuses) them onto analysis apparatus, such as a detection/imaging device, spectroscopic apparatus (such as an EELS module), *etc.* As with the illuminator referred to above, the imaging system may also perform other functions, such as aberration mitigation, cropping, filtering, *etc.,* and it will generally comprise one or more charged-particle lenses and/or other types of particle-optical components.

In what follows, the invention may - by way of example - sometimes be set forth in the specific context of electron microscopy. However, such simplification is intended solely for clarity/illustrative purposes, and should not be interpreted as limiting.

A particularly important class of specimen holder for use in a CPM is a so-called cryogenic (transfer) holder, which can be used to maintain a specimen at a relatively low temperature, specifically at cryogenic temperatures (at or below -150°C, for example). Such holders are designed to maintain a low specimen temperature not only when the holder is *in situ* in the CPM, but also when it is *ex situ, e.g.* during transfer of the specimen from one CPM to another, or to and from a specimen preparation/storage station. To this end, the holder comprises a carry-along vessel (such as a mini-dewar) of coolant fluid (such as liquid nitrogen or liquid oxygen, for example) which is thermally connected to the specimen *via* an elongated (and substantially straight) member, such as a rod / shaft / pipe comprising material of good thermal conductivity (*e.g.* a metal such as copper or aluminum, for instance). Such a construction allows the specimen-carrying elongated member to be inserted through an aperture/door in a retaining wall (such as a vacuum/environmental enclosure of a CPM, or an airlock, for example) in such a manner that the vessel remains outside the wall (in engagement with a sealing element, such as an O-ring, for example) while the specimen is located (relatively far) inside the wall.

Many procedures performed in a CPM require the specimen to be tilted relative to an irradiating beam of charged particles, *e.g.* as in the case of TEM tomography and FIB machining, for instance. In such situations, a holder as described in the previous paragraph can be rotated about a longitudinal/cylindrical axis of the elongated member, so as to adjust the so-called "alpha tilt" or "roll angle" of the specimen. To effect such rotation, the portion of the holder inside the CPM can (for example) be seated in a cradle that is connected to a rotation/translation actuator (*e.g.* the so-called CompuStage in TEMs built by FEI Company); the seated/clamped specimen holder then rotates/translates passively together with the actively driven cradle.

The inventors have determined that there are many situations in which prior-art specimen holders perform sub-optimally. In that context, the current inventors have worked extensively to identify shortcomings in conventional holder designs, and to address these effectively so as to produce better performance. The results of this endeavor are the subject of the current invention.

It is an object of the invention to provide an improved specimen holder of the type set forth above. In particular, it is an object of the invention that such a specimen holder should have a structure that lends itself to maintaining better thermal equilibrium in the holder itself and in a specimen mounted thereupon.

These and other objects are achieved in a specimen holder as set forth in the opening paragraph above, characterized in that said elongated member can be rotated about said longitudinal axis relative to said vessel.

A problem with prior-art specimen holders - such as that described in United States Patent US 5,753,924, for example - is that the connection means (*e.g.* a weld or solder joint, or a screw-fastened abutment) between the elongated member and the vessel are rigid in nature; consequently, if the elongated member is rotated about its longitudinal axis (*e.g.* by an actuated cradle as referred to above), then the vessel will co-rotate with it. Such co-rotation will cause movement of the coolant fluid in the vessel, and the inventors have observed that this can significantly influence the temperature stability/equilibrium of the attached elongated member and the specimen mounted thereon; in particular, movement of the fluid within the vessel will tend to cause changes in the temperature distribution within the vessel wall, and agitation of the coolant fluid can even cause it to locally boil. If such movement is severe enough, then spillage/splattering of coolant fluid out of the vessel can occur, with attendant safety risks for users of the holder, and also the possibility that the fluid within the vessel will be (prematurely) depleted. Moreover, the aforementioned boiling behavior causes vibrations that can adversely influence imaging performance. The present invention addresses these problems by embodying the connection means between the vessel and elongated member to allow relative rotation between the two - more specifically to allow the elongated member to be rotated without the vessel having to co-rotate. In this way, the elongated member (*e.g.* inserted within a CPM) can be rotated to a desired roll angle / alpha tilt (*e.g.* by an actuated cradle) whilst maintaining the vessel (and the coolant fluid therein) essentially stationary, thus avoiding undesired movement/tilting/sloshing of the coolant fluid in the vessel. Moreover, because the vessel does not have to co-rotate with the elongated member - but can instead remain level - one can now entirely (rather than partly) fill the vessel with coolant fluid, thus allowing longer time intervals between refills, with accordingly less interruption of extended measurement sessions performed with the holder (such as TEM tomographic tilt series / sinogram acquisition, for instance).

In a particular embodiment of the invention, said connection means comprise a bearing chase that facilitates said rotation of the elongated member relative to the vessel. Such a bearing chase will typically comprise a nested pair of annular retainer flanges with an interposed ring of (*e.g.* ball or cylindrical) bearings, which allow the inner flange to rotate smoothly relative to the outer flange. In such an instance, one could, for example, rigidly attach (*e.g.* weld/solder) the outer flange to a wall of the vessel and arrange (a portion of) the elongated member to be rigidly affixed (*e.g.* welded/soldered) within the inner flange. Apart from (or in addition to) using a bearing chase in this way one could, for example, provide a wall of the vessel with a (round) bore (sleeve/tunnel) into which the (round) elongated member is inserted in such a manner as to give an intimate fit (with minimal lateral play) while nevertheless allowing rotation of the member within the bore.

In addition to providing a satisfactory (rotary) mechanical connection between the vessel and elongated member, there should also be a satisfactory thermal connection between the two, so that - regardless of the rotational stance/angle (attitude/orientation/posture) of the elongated member - heat can still be efficiently extracted therefrom (and the specimen mounted thereon) by the coolant fluid in the vessel. One possible way to achieve such a thermal connection would be *via* abutment, *e.g.* by providing said first end of the elongated member with a (coaxial) disk-shaped termination that abuts against a flat portion of vessel wall - and that remains abutted if the elongated member is rotated. However, in an alternative (or supplemental) embodiment, a compliant element (such as a braided metallic "rope") is used to form a flexible thermal bridge between the vessel and the attached elongated member. In such an arrangement, the compliant element essentially acts as a thermal umbilical cord between the vessel and elongated member, allowing relative rotation of the two whilst maintaining a heat drain from the elongated member into the vessel. In the case of a rotary connection *via* a (metallic) bearing chase as set forth in the previous paragraph, the very structure of the bearing chase ensures that heat can leak from the elongated member *via* the inner flange, bearings and outer flange into the vessel wall - though one may wish to supplement such leakage using a compliant element and/or abutment arrangement as referred to above.

As set forth above, when inserted into an enclosure (such as the vacuum/environmental chamber of a CPM, an airlock, *etc.),* a holder according to the current invention will typically be arranged so that the elongated member protrudes through a wall aperture/door into an interior space of the enclosure whilst the vessel remains outside the enclosure. In such a situation, there are various ways in which to keep the vessel in a particular orientation (*e.g.* upright) regardless of the rotational stance (roll angle / alpha tilt) of the elongated member. One rudimentary way is to weight (a lower portion of) the vessel so that its center of mass is (well) below the level of the longitudinal axis; in such an arrangement, gravity will automatically exert a correctional reverse torque in response to any torque exerted on the vessel as a result of rotating the elongated member (*e.g.* due to friction in the employed rotary connection means). An even more elementary approach would be to mechanically constrict possible co-rotational motion of the vessel, *e.g.* by "straightjacketing" the vessel between structures such as lips, rails, pips, *etc.,* provided (for instance) on an external surface of the enclosure wall, or by actually (removably) fixing the vessel to the wall (*e.g.* using a clamp, screw, *etc.).* However, in a more sophisticated approach, the employed connection means comprise an onboard actuator for effecting relative rotation of said elongated member and said vessel about said longitudinal axis, which actuator comprises an input interface for receiving a control signal from a controller (driver, regulator) for effecting automatic (autonomous) levelling of said vessel independent of a rotational stance of said elongated member. In such a scenario, the controller may, for example, make use of an orientation signal from a tilt sensor, inertial sensor, gravity sensor, *etc.,* in conjunction with a simple feedback loop / null regulation; alternatively or supplementally, the controller may use a rotational setpoint issued to a driven cradle (*e.g.* CompuStage) as referred to above as the basis for sending a compensatory (negatory) setpoint to said onboard actuator. The controller (such as a computer processor or dedicated electronic circuit, for example) may be present *in situ* (onboard) on the specimen holder itself (*e.g.* comprised in/near said connection means), but it may also be an *ex situ* / remote controller that is connected to the actuator *via* a jack/socket/cable, for example. The employed actuator may, for example, be a conventional DC electric motor, piezoelectric actuator or voice coil motor, which (*e.g.* together with an onboard controller) can get its power from an onboard battery (integrated in the holder) and/or an external source (*e.g. via* a hookup before/when the holder is inserted into an enclosure). An advantage of an "active" levelling approach of this type is that it acts as a failsafe fallback if - for whatever reason - the vessel starts to co-rotate with the elongated member (*e.g.* due to inertial/friction/hysteresis effects, human error, mechanical failure, *etc.).* In particular, it allows the vessel to be kept level during transport, insertion/de-insertion and general handling of the holder, especially in situations in which it is necessary (or more convenient) to grasp the holder *via* the elongated member instead of *via* the vessel.

As already alluded to above, the connection means of the present invention can advantageously comprise a vacuum seal between said elongated member and said vessel. Such a seal may be singular or composite in structure, and may, for example, comprise a rubber/polymer element such as an O-ring/X-ring, or a metal bellows-like seal, for instance. The seal may be inside and/or outside the connection means, according to need/desire. Such a seal may, for example, have the following functions:
- To isolate the interior of a (vacuum) enclosure from the (non-vacuum) exterior of the enclosure at a location (entrance aperture/port) where the inventive specimen holder is mounted so as to protrude into the enclosure; and/or
- To isolate a vacuum space within nested walls of the vessel from an atmospheric space within the (adjacent) connection means.

The invention will now be elucidated in more detail on the basis of exemplary embodiments and the accompanying schematic drawings, in which:
Figure 1 renders a plan view and a longitudinal cross-sectional view of an embodiment of a specimen holder according to the current invention.
Figure 2 renders a cross-sectional view of an embodiment of a (transmission-type) charged particle microscope in which the present invention can be enacted.

In the Figures, where pertinent, corresponding parts may be indicated using corresponding reference symbols.

### Embodiment 1

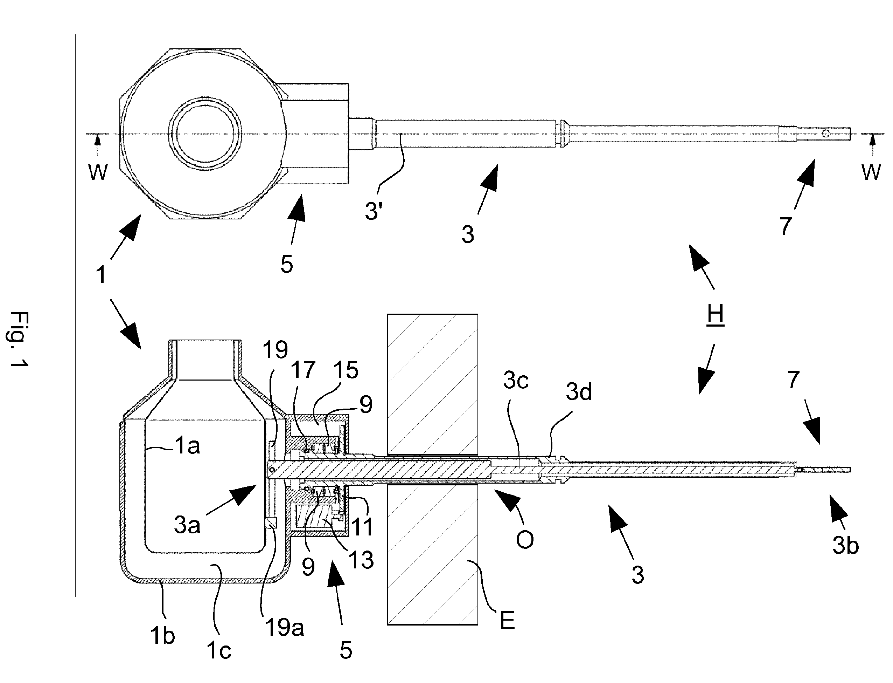

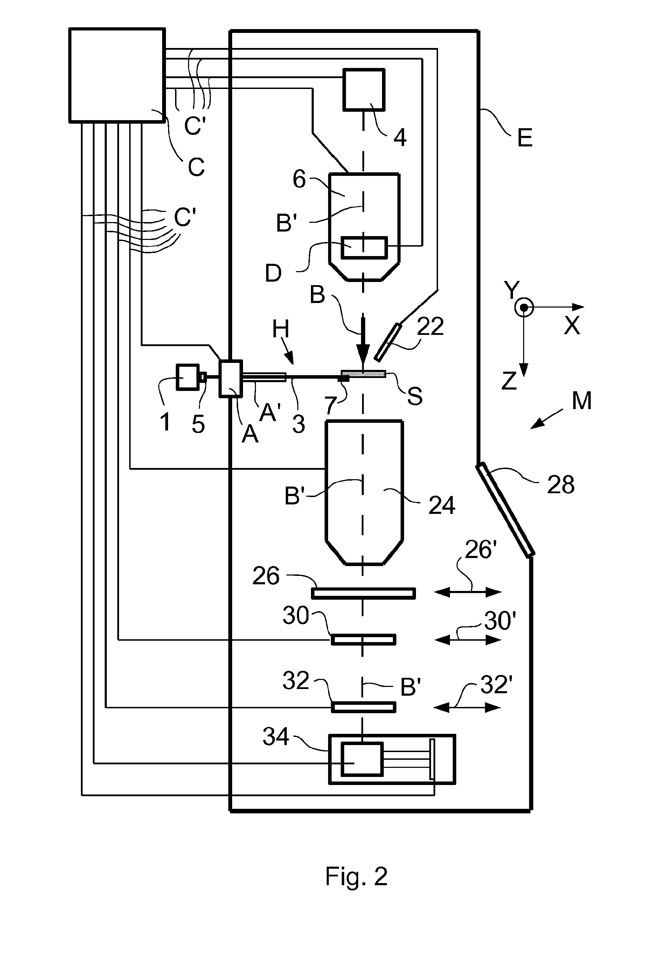

Figure 1 (which should be viewed landscape rather than portrait) renders a plan view (top) and a longitudinal cross-sectional view (bottom; viewed along line W-W) of an embodiment of a specimen holder H according to the current invention. The subject of the Figure is approximately half life size (on an A4 sheet), and comprises the following components:
1: A vessel for containing a coolant/cryogenic fluid, such as liquid nitrogen. As here depicted, the vessel 1 is a mini-dewar (flask) with an inner wall 1 a, outer wall 1 b and intervening insulating (vacuum) space 1 c. The vessel 1 can be (fully or partially) filled with coolant fluid prior to (and also during/after) use of the holder.
3: An elongated member (arm/finger/shaft). This has a first end 3a that is thermally connected to the vessel 1 *via* connection means 5, and a second end 3b that comprises a specimen mounting area 7. As here depicted, the elongated member 3 has a composite structure, and comprises an inner conducting rod 3c (comprising a good thermally conducting material, such as copper or aluminum, for example) within an outer shell/casing 3d. The elongated member 3 has a longitudinal (substantially cylindrical) axis 3' that extends along its length between said first end 3a and second end 3b. In accordance with the invention, the elongated member 3 can be rotated (rolled, alpha-tilted) about this axis 3' relative to the vessel 1.
7: Said specimen mounting area, here depicted as a flattened (paddle-like) region onto which a specimen S (not depicted; see Figure 2) can be mounted, *e.g.* using adhesive or a (mechanical) clamping mechanism (*e.g.* comprising a spring, clip, screw, lip, *etc.).* As here illustrated, the specimen mounting area 7 comprises a through-hole to allow passage of a charged-particle beam B therethrough (see Figure 2); alternatively, a mounted specimen S could simply protrude (overhang) past an extremity of item 7. E: An enclosure, such as the vacuum/environmental chamber of a CPM (see Figure 2). This is only depicted in the lower (cross-sectional) part of Figure 1 (so as to avoid cluttering), and the depiction comprises only a small portion of a retaining wall of the enclosure. The enclosure E contains an aperture O through which the elongated member 3 protrudes, so that the sample mounting area 7 is located inside the enclosure E whilst the vessel 1 remains outside E. As depicted in Figure 2, item 3 may be seated into a cradle A' that can be rotated/translated by an actuator/stage A. 5: Said connection means, which, as here depicted, have a composite structure comprising the following items:
   9: A bearing chase that facilitates relative rotation of items 3 and 1. An outer retaining flange of this bearing chase 9 is attached to a protrusion from outer wall 1 b of vessel 1, and an inner retaining flange of bearing chase 9 is attached to outer shell/casing 3d of elongated member 3, with an interposed set of bearings allowing free rotation of the inner flange relative to the outer flange. Items 9 and 3 are substantially concentric.
   11: A cog (drive wheel) that is (concentrically) attached to item 3d, and that engages with a rotary actuator 13 that can be invoked to cause the cog 11 to rotate about axis 3', thereby causing relative rotation of items 1 and 3 about axis 3'. In the current embodiment, this actuator 13 is used to effect correctional levelling/righting of vessel 1 should it (for whatever reason) start to rotate away from a vertical orientation; however, as an alternative, in the absence of an actuated cradle A' as referred to above (see Figure 2), the rotary actuator 13 could also be used to vary the roll angle of specimen mounting area 7 assuming that vessel 1 is (mechanically) constrained to remain in a vertical orientation.
   15: A level sensor (such as a MEMS level sensor or mercury switch, for example) that can be used to sense non-verticality of vessel 1. A signal from sensor 15 can be used as the basis for a correctional (righting) signal to actuator 13.
   17: A vacuum (rotation) seal, such as an O-ring or Quad-ring / X-ring, for example.
   19: A compliant, thermally-conducting element (such as a braided copper "rope") that forms a flexible thermal bridge between vessel 1 and elongated member 3. For this purpose, one end of element 19 is attached to inner wall 1 a of vessel 1 *via* an anchor 19a (such as a blob of solder), and the other end of element 19 is attached to first end 3a of elongated member 3.

### Embodiment 2

Figure 2 is a highly schematic depiction of an embodiment of a CPM according to the current invention; more specifically, it shows an embodiment of a transmission-type microscope M, which, in this case, is a TEM/STEM (though, in the context of the current invention, it could just as validly be an ion-based microscope, for example). In the Figure, within a vacuum enclosure E, an electron source 4 (such as a Schottky emitter, for example) produces a beam (B) of electrons that traverse an electron-optical illuminator 6, serving to direct/focus them onto a chosen part of a specimen S (which may, for example, be (locally) thinned/planarized). This illuminator 6 has an electron-optical axis B', and will generally comprise a variety of electrostatic / magnetic lenses, (scan) deflector(s) D, correctors (such as stigmators), *etc*.; typically, it can also comprise a condenser system (the whole of item 6 is sometimes referred to as "a condenser system").

The specimen S is held on a specimen holder H according to the present invention, such as that depicted in Figure 1. As here illustrated, part of this holder H (inside enclosure E) is mounted in a cradle A' that can be positioned/moved in multiple degrees of freedom by a positioning device (stage) A; for example, the cradle A' may be displaced (*inter alia*) in the X, Y and Z directions (see the depicted Cartesian coordinate system), and may be rotated about a longitudinal axis 3' (see Figure 1) parallel to X (roll, alpha tilt, Rx). Such movement allows different parts of the specimen S to be irradiated / imaged / inspected by the electron beam traveling along axis B' (and/or allows scanning motion to be performed as an alternative to beam scanning [using deflector(s) D], and/or allows selected parts of the specimen S to be machined by a (non-depicted) focused ion beam, for example).

The (focused) electron beam B traveling along axis B' will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of detector 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the specimen S, emerge (emanate) from it and continue to propagate (substantially, though generally with some deflection/scattering) along axis B'. Such a transmitted electron flux enters an imaging system (combined objective/projection lens) 24, which will generally comprise a variety of electrostatic / magnetic lenses, deflectors, correctors (such as stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the specimen S will be formed by imaging system 24 on screen 26, and this may be viewed through viewing port 28 located in a suitable part of a wall of enclosure V. The retraction mechanism for screen 26 may, for example, be mechanical and/or electrical in nature, and is not depicted here.

As an alternative to viewing an image on screen 26, one can instead make use of the fact that the depth of focus of the electron flux emerging from imaging system 24 is generally quite large (*e.g.* of the order of 1 meter). Consequently, various types of detector / analysis apparatus can be used downstream of screen 26, such as:
- TEM camera (detector) 30. At camera 30, the electron flux can form a static image (or diffractogram) that can be processed by controller C and displayed on a display device (not depicted), such as a flat panel display, for example. When not required, camera 30 can be retracted/withdrawn (as schematically indicated by arrows 30') so as to get it out of the way of axis B'.
- STEM recorder (detector) 32. An output from recorder 32 can be recorded as a function of (X,Y) scanning position of the beam B on the specimen S, and an image can be constructed that is a "map" of output from recorder 32 as a function of X,Y. Recorder 32 can comprise a single pixel with a diameter of *e.g.* 20 mm, as opposed to the matrix of pixels characteristically present in camera 30. Moreover, recorder 32 will generally have a much higher acquisition rate (*e.g.* 10⁶ points per second) than camera 30 (*e.g.* 10² images per second). Once again, when not required, recorder 32 can be retracted/withdrawn (as schematically indicated by arrows 32') so as to get it out of the way of axis B' (although such retraction would not be a necessity in the case of a donut-shaped annular dark field recorder 32, for example; in such a recorder, a central hole would allow beam passage when the recorder was not in use).
- As an alternative to imaging using camera 30 or recorder 32, one can also invoke spectroscopic apparatus (detector) 34, which could be an EELS module, for example (EELS = Electron Energy-Loss Spectroscopy).
It should be noted that the order/location of items 30, 32 and 34 is not strict, and many possible variations are conceivable. For example, spectroscopic apparatus 34 can also be integrated into the imaging system 24.

Note that the controller (computer processor) C is connected to various illustrated components *via* control lines (buses) C'. This controller C can provide a variety of functions, such as synchronizing actions, providing setpoints, processing signals, performing calculations, and displaying messages/information on a display device (not depicted). Needless to say, the (schematically depicted) controller C may be (partially) inside or outside the enclosure E, and may have a unitary or composite structure, as desired. The skilled artisan will understand that the interior of the enclosure E does not have to be kept at a strict vacuum; for example, in a so-called "Environmental TEM/STEM", a background atmosphere of a given gas is deliberately introduced/maintained within the enclosure E. The skilled artisan will also understand that, in practice, it may be advantageous to confine the volume of enclosure E so that, where possible, it essentially hugs the axis B', taking the form of a small tube (*e.g.* of the order of 1 cm in diameter) through which the employed electron beam passes, but widening out to accommodate structures such as the source 4, specimen holder H, screen 26, camera 30, recorder 32, spectroscopic apparatus 34, *etc.*

In accordance with the current invention, the specimen S can be rotated about axis 3' (X) at will without risk of co-rotation of the vessel 1. In this way, one prevents motion (sloshing, spillage) of coolant fluid (cryogen) in vessel 1, thus helping to maintain a stable thermal equilibrium of holder H and specimen S. In addition, one impedes agitation-induced boiling of coolant fluid, and the vibration / imaging degradation attendant thereto.

It should be noted that, although the discussion above concentrates on a transmission-type CPM, the current invention is just as applicable in a non-transmission-type CPM, such as a SEM.

## Claims

1. A specimen holder for a Charged Particle Microscope, comprising:
- A vessel for containing a coolant fluid;
- An elongated member, a first end of which is thermally connected to said vessel *via* connection means and the second end of which comprises a specimen mounting area, the member having a longitudinal axis that extends along its length between said first and second ends,
**characterized in that** said elongated member can be rotated about said longitudinal axis relative to said vessel.

2. A specimen holder according to claim 1, wherein said connection means comprise a bearing chase that facilitates said rotation.

3. A specimen holder according to claim 1 or 2, wherein said connection means comprise a compliant element that forms a flexible thermal bridge between said vessel and said elongated member.

4. A specimen holder according to any of claims 1-3, wherein said connection means comprise an actuator for effecting relative rotation of said elongated member and said vessel about said longitudinal axis, which actuator comprises an input interface for receiving a control signal from a controller for effecting automatic levelling of said vessel independent of a rotational stance of said elongated member.

5. A specimen holder according to any of claims 1-4, wherein said connection means comprise a vacuum seal between said elongated member and said vessel.

6. A method of using a Charged Particle Microscope, comprising the following steps:
- Providing a specimen on a specimen mounting area of a specimen holder;
- Introducing said specimen mounting area into a vacuum enclosure of the microscope;
- Directing a beam of charged particles from a source through an illuminator along a particle-optical axis so as to irradiate the specimen;
- Using a detector to detect a flux of radiation emanating from the specimen in response to said irradiation,
wherein use is made of a specimen holder comprising:
- A vessel containing a coolant fluid;
- An elongated member, a first end of which is thermally connected to said vessel *via* connection means and the second end of which comprises said specimen mounting area, the member having a longitudinal axis that extends along its length between said first and second ends,
which elongated member can be rotated about said longitudinal axis relative to said vessel.

7. A method according to claim 6, wherein, after introducing said specimen mounting area into said enclosure, said elongated member is rotated about said longitudinal axis so as to adjust a stance of the specimen relative to said particle-optical axis while keeping said vessel substantially level.

8. A Charged Particle Microscope, comprising:
- A specimen holder, for holding a specimen;
- A source, for producing a beam of charged particles;
- An illuminator, for directing said beam so as to irradiate the specimen;
- A detector, for detecting a flux of radiation emanating from the specimen in response to said irradiation;
which specimen holder is a specimen holder as claimed in any of claims 1-5.
